(19) Europäisches Patentamt
European Patent Office
Office européen des brevets

(11) **EP 2 638 623 B1**

(12) **EUROPÄISCHE PATENTSCHRIFT**

(45) Veröffentlichungstag und Bekanntmachung des Hinweises auf die Patenterteilung:
**28.11.2018 Patentblatt 2018/48**

(51) Int Cl.:
**H02M 1/08** *(2006.01)* **H03K 17/567** *(2006.01)*
**H02M 1/084** *(2006.01)* **H03K 17/16** *(2006.01)*

(21) Anmeldenummer: **12701697.0**

(22) Anmeldetag: **13.01.2012**

(86) Internationale Anmeldenummer:
**PCT/EP2012/050503**

(87) Internationale Veröffentlichungsnummer:
**WO 2012/107258 (16.08.2012 Gazette 2012/33)**

(54) **VERFAHREN ZUR STEUERUNG ZWEIER ELEKTRISCH IN REIHE GESCHALTETER RÜCKWÄRTS LEITFÄHIGER IGBTS EINER HALBBRÜCKE**

METHOD FOR CONTROLLING TWO ELECTRICALLY SERIES-CONNECTED REVERSE CONDUCTIVE IGBTS OF A HALF BRIDGE

PROCÉDÉ DE COMMANDE DE DEUX IGBT MONTÉS ÉLECTRIQUEMENT EN SÉRIE À CONDUCTION INVERSE D'UN DEMI-PONT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.02.2011 DE 102011003938**

(43) Veröffentlichungstag der Anmeldung:
**18.09.2013 Patentblatt 2013/38**

(73) Patentinhaber: **Siemens Aktiengesellschaft 80333 München (DE)**

(72) Erfinder: **ECKEL, Hans-Günter 18059 Rostock (DE)**

(56) Entgegenhaltungen:
DE-A1- 10 206 392        DE-A1-102009 030 738
DE-A1-102009 030 739     DE-A1-102009 030 740

- **RAHIMO M ET AL: "A High Current 3300V Module Employing Reverse Conducting IGBTs Setting a New Benchmark in Output Power Capability", POWER SEMICONDUCTOR DEVICES AND IC'S, 2008. ISPSD '08. 20TH INTERNATIONAL SYMPOSIUM ON, IEEE, PISCATAWAY, NJ, USA, 18 May 2008 (2008-05-18), pages 68-71, XP031269936, ISBN: 978-1-4244-1532-8**

EP 2 638 623 B1

**Beschreibung**

Die Erfindung bezieht sich auf ein Verfahren zur Steuerung zweier elektrisch in Reihe geschalteter rückwärts leitfähiger IGBTs einer Halbbrücke, an der eine Betriebsgleichspannung ansteht, wobei diese rückwärts leitfähigen IGBTs über drei Schaltzustände "+15V", "0V" und "-15V" verfügen.

Rückwärts leitfähige IGBTs sind auch als Reverse-Conducting IGBTs (RC-IGBT) bekannt. Ein RC-IGBT unterscheidet sich von einem herkömmlichen IGBT dadurch, dass die Dioden-Funktion und die IGBT-Funktion in einem Chip vereint sind. Dadurch entsteht ein Leistungshalbleiter, bei dem die Anodeneffizienz im Dioden-Modus von einer anstehenden Gate-Spannung abhängig ist.

Aus der DE 10 2009 030 740 A1 ist ein ereignisgesteuertes Verfahren zur Kommutierung von einem im Dioden-Modus betriebenen rückwärts leitfähigen IGBT auf einen im IGBT-Modus betriebenen rückwärts leitfähigen IGBT bekannt.

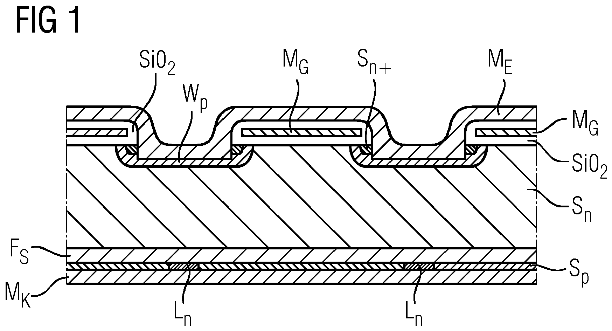

Die Basisstruktur eines RC-IGBTs ist in FIG 1 als Querschnitt näher dargestellt. Dieser Aufbau ist aus der Veröffentlichung "A High Current 3300V Module Employing Reverse Conducting IGBTs Setting a New Benchmark in Output Power Capability" von M. Rahimo, U. Schlapbach, A. Kopta, J. Vobecky, D. Schneider, A. Baschnagel, abgedruckt in ISPSD 2008, bekannt. Diese Basisstruktur besteht aus einem schwach n-dotierten Substrat $S_n$, der kollektorseitig mit einer n-dotierten Schicht $F_s$ versehen ist. Auf dieser Schicht $F_S$ ist eine hochdotierte p-Schicht $S_p$ aufgebracht, die ihrerseits mit einer Metallschicht $M_K$ versehen ist. In dieser hochdotierten p-Schicht $S_p$ sind hochdotierte n-Bereiche $L_n$ derart angeordnet, dass diese im Schatten von in dem schwach n-dotierten Substrat $S_n$ eingelassenen hochdotierten p-Bereichen $W_p$ liegen. Diese sind derart ausgebildet, dass diese jeweils eine so genannte Wanne um eine Absenkung einer Metallschicht $M_E$, die als Emitteranschluss des RC-IGBTs dient, bilden. Diese Absenkungen durchbrechen jeweils eine weitere Metallschicht $M_G$, die gegenüber der Metallschicht $M_E$, die als Emitteranschluss des RC-IGBTs dient, und gegenüber dem schwach n-dotierten Substrat $S_n$ von einer Siliciumoxid-Schicht umgeben ist. Außerdem ist jede Absenkung der als Emitteranschluss dienende Metallschicht $M_E$ in dem wannenförmig ausgebildeten hochdotierten p-Bereich $W_p$ mit einer hochdotierten n-Schicht $S_{n+}$ umgeben.

Bei einer Gate-Emitter-Spannung unterhalb einer Schwellspannung des MOS-Kanals (-15V) eines rückwärts leitfähigen IGBTs ist die Anodeneffizienz hoch, wodurch die Ladungsträgerdichte im Durchlasszustand hoch und die Durchlassspannung niedrig sind. Die Reverse-Recovery-Ladung, die Reverse-Recovery-Verluste und die Einschaltverluste eines im Brückenzweig gegenüberliegenden RC-IGBT sind dagegen hoch. Bei einer Gate-Emitter-Spannung oberhalb einer Schwellspannung (+15V) des MOS-Kanals eines rückwärts leitfähigen IGBTs ist die Anodeneffizienz niedrig, wodurch die Ladungsträgerdichte im Durchlasszustand niedrig und die Durchlassspannung hoch sind. Da der MOS-Kanal eingeschaltet ist, kann dieser RC-IGBT keine Sperrspannung aufnehmen.

Aufgrund dieser Tatsache kann eine Ansteuerung und damit ein Verfahren zur Steuerung eines herkömmlichen IGBTs nicht bei einem rückwärts leitfähigen IGBT verwendet werden. Wie ein Verfahren zur Steuerung eines RC-IGBTs aussehen kann, ist der bereits erwähnten Veröffentlichung zu entnehmen. Charakteristisch für dieses Verfahren ist, dass der Schaltzustand des rückwärts leitfähigen IGBTs nicht nur von einem Sollwert einer Ausgangsspannung eines mehrphasigen Stromrichters mit RC-IGBTs als Stromrichterventile abhängt, sondern auch von einer Stromrichtung des Kollektorstroms.

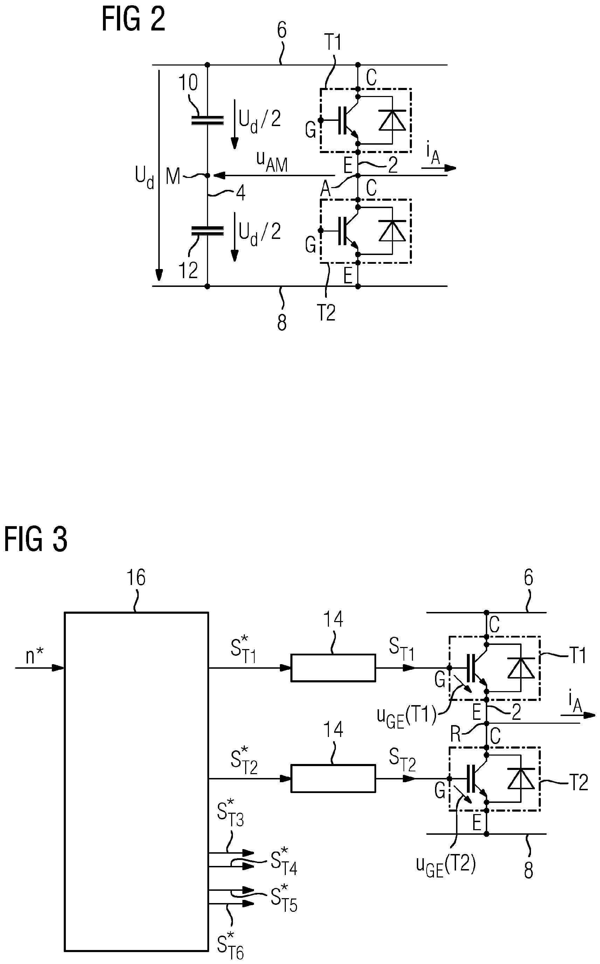

Die FIG 2 zeigt ein Ersatzschaltbild eines Brückenzweigs 2 eines Stromrichters, wobei RC-IGBTs T1 und T2 als Stromrichterventile verwendet werden. Dieser Brückenzweig 2, auch als Halbbrücke bezeichnet, ist mittels zweier Stromschienen 6 und 8 elektrisch parallel zu einer Gleichspannungsquelle 4 geschaltet. Die beiden rückwärts leitfähigen IGBTs T1 und T2 des Brückenzweigs 2 sind elektrisch in Reihe geschaltet. Ein Verbindungspunkt dieser beiden rückwärts leitfähigen IGBTs T1 und T2 bilden einen wechselspannungsseitigen Anschluss A, an dem eine Last anschließbar ist. Die Gleichspannungsquelle 4 weist zwei Kondensatoren 10 und 12 auf, die ebenfalls elektrisch in Reihe geschaltet sind. Ein Verbindungspunkt dieser beiden Kondensatoren 10 und 12 bildet einen Mittelpunkt-Anschluss M. An diesen beiden elektrisch in Reihe geschalteten Kondensatoren 10 und 12 steht eine Gleichspannung $U_d$ an. Alternativ kann statt der beiden Kondensatoren 10 und 12 auch nur ein Kondensator verwendet werden, der zwischen den beiden Stromschienen 6 und 8 angeordnet ist. Der Mittelpunkt M ist dann nicht mehr zugänglich. Bei einem Spannungszwischenkreis-Umrichter bildet diese Gleichspannungsquelle 4 einen Spannungszwischenkreis, wobei die anstehende Gleichspannung $U_d$ dann als Zwischenkreisspannung bezeichnet wird. Der Brückenzweig 2 ist bei einem dreiphasigen Stromrichter, insbesondere einem Pulsstromrichter, der als lastseitiger Stromrichter eines Spannungszwischenkreis-Umrichters verwendet wird, drei Mal vorhanden. Am wechselspannungsseitigen Ausgang A steht bezogen auf den Mittelpunkt-Anschluss M der Gleichspannungsquelle 4 eine pulsweitenmodellierte Rechteckspannung $U_{AM}$ an.

In der FIG 3 ist ein Blockschaltbild einer Steuer- und Regeleinrichtung eines dreiphasigen Stromrichters, insbesondere eines Pulsstromrichters, eines Spannungszwischenkreis-Umrichters mit zugehörigen halbleiternahen Ansteuervorrichtungen 14 eines Brückenzweigs 2 dieses Stromrichters dargestellt. Eine Steuereinrichtung 16 generiert in Abhängigkeit eines Sollwertes, beispielsweise eines Drehzahl-Sollwertes n*, pro Brückenzweig 2 zwei Soll-Steuersignale

$S_{T1}^*$, $S_{T2}^*$, $S_{T3}^*$, $S_{T4}^*$, $S_{T5}^*$ und $S_{T6}^*$. Aus Übersichtlichkeitsgründen ist von den drei Brückenzweigen eines dreiphasigen Stromrichters nur der Brückenzweig 2 dargestellt. Die beiden Soll-Steuersignale $S_{T1}^*$ und $S_{T2}^*$ sind jeweils einer halbleiternahen Ansteuervorrichtung 14 eines jeden rückwärts leitfähigen IGBTs T1 und T2 des Brückenzweigs 2 zugeführt. Ausgangsseitig steht jeweils ein Ist-Steuersignal S$_{T1}$ bzw. S$_{T2}$ an, mit dem ein Gate G eines zugehörigen rückwärts leitfähigen IGBTs T1 bzw. T2 angesteuert wird. In dieser Darstellung ist der wechselspannungsseitige Anschluss des Brückenzweigs 2 nicht wie in der Darstellung der FIG 1 mit A, sondern mit R bezeichnet. Die drei Brückenzweige eines dreiphasigen Stromrichters sind mittels der beiden Stromschienen 6 und 8 zueinander und zur Gleichspannungsquelle 4 elektrisch parallel geschaltet.

Wie bereits erwähnt, ist der stationäre Schaltzustand der beiden rückwärts leitfähigen IGBTs T1 und T2 eines Brückenzweigs 2 nicht nur vom Sollwert einer Ausgangsspannung $u_{AM}^*$, sondern auch von der Polarität eines Ausgangsstroms i$_A$ dieses Brückenzweigs 2 abhängig. Immer dann, wenn der rückwärts leitfähige IGBT T1 bzw. T2 in Rückwärtsrichtung Strom führen soll (negativer Kollektorstrom, Diodenmodus), wird er ausgeschaltet. Auf diese Weise wird die Ladungsträgerkonzentration im Dioden-Modus angehoben. Aus der folgenden Tabelle sind die Schaltzustände der beiden rückwärts leitfähigen IGBTs T1 und T2 des Brückenzweigs 2 entnehmbar:

| u$_{A0(soll)}$ | i$_{A(ist)}$ | T1 | T2 |
|---|---|---|---|
| + U$_d$/2 | > 0 | ein | aus |
| + U$_d$/2 | < 0 | aus | aus |
| - U$_d$/2 | > 0 | aus | aus |
| - U$_d$/2 | < 0 | aus | ein |

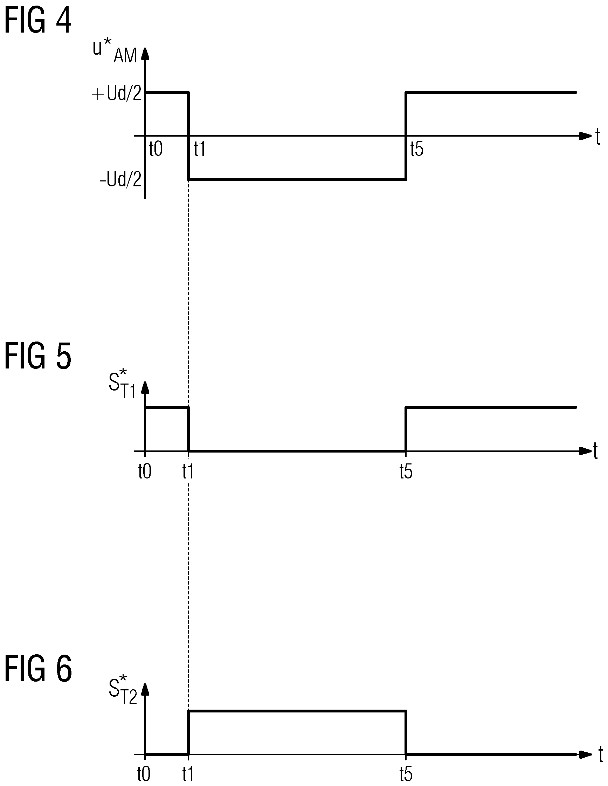

In den FIG 4 bis 8 sind Signalverläufe jeweils in einem Diagramm über der Zeit t für den Fall dargestellt, dass für negative Polarität des Ausgangsstroms i$_A$ der rückwärts leitfähige IGBT T1 im Dioden-Modus und der rückwärts leitfähige IGBT T2 im IGBT-Modus betrieben werden. In der FIG 4 ist der Verlauf der Soll-Ausgangsspannung $u_{AM}^*$ über der Zeit t dargestellt. Um diese Soll-Ausgangsspannung $u_{AM}^*$ umsetzen zu können, werden die Soll-Steuersignale $S_{T1}^*$ und $S_{T2}^*$ benötigt, deren zeitliche Verläufe in den FIG 5 und 6 über der Zeit t dargestellt sind.

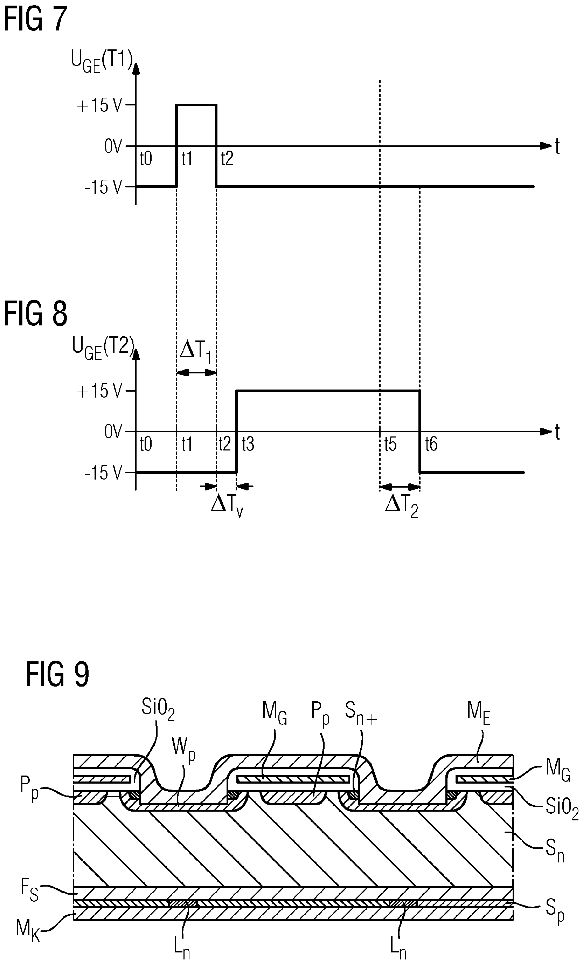

Zum Zeitpunkt t0 ist der Wert der Soll-Ausgangsspannung $u_{AM}^*$ gleich der halben an der Gleichspannungsquelle 4 anstehenden Gleichspannung U$_d$. Dadurch ist der im Dioden-Modus betriebene rückwärts leitfähige IGBT T1 stromführend. Damit im Dioden-Modus dieser rückwärts leitfähige IGBT T1 Strom führen kann, muss dieser ausgeschaltet sein. In dem Signalverlauf des Diagramms gemäß FIG 7, der den Verlauf der Gate-Spannung u$_{GE}$(T1) des rückwärts leitfähigen IGBTs T1 über der Zeit t veranschaulicht, befindet sich die Gate-Spannung im Aus-Zustand (-15V). Zu diesem Zeitpunkt befindet sich der Schaltzustand des rückwärts leitfähigen IGBTs T2 gemäß der Gate-Spannung u$_{GE}$(T2) entsprechend der FIG 8 ebenfalls im Aus-Zustand. Zum Zeitpunkt t1 wechselt die Soll-Ausgangsspannung $u_{AM}^*$ von +U$_d$/2 auf -U$_d$/2. Zu diesem Zeitpunkt t1 wechselt das Soll-Steuersignal $S_{T1}^*$ von high nach low, wogegen das Soll-Steuersignal $S_{T2}^*$ von low nach high wechselt. Dadurch wird der im Dioden-Modus betriebene rückwärts leitfähige IGBT T1 für eine vorbestimmte Zeitspanne ΔT$_1$ eingeschaltet, wobei der im IGBT-Modus betriebene IGBT T2 weiterhin im ausgeschalteten Zustand bleibt. In dieser vorbestimmten Zeitspanne ΔT$_1$ ist der im Dioden-Modus betriebene rückwärts leitfähige IGBT T1 weiterhin stromführend, wodurch die Ladungsträgerkonzentration absinkt.

Zum Zeitpunkt t2 wird der im Dioden-Modus betriebene rückwärts leitfähige IGBT T1 wieder abgeschaltet. Nach Ablauf einer weiteren vorbestimmten Zeitspanne ΔT$_V$, die auch als Verriegelungszeit bezeichnet wird, wird zum Zeitpunkt t3 der im IGBT-Modus betriebene rückwärts leitfähige IGBT T2 eingeschaltet (FIG 8). Die Kommutierung vom im Dioden-Modus betriebenen IGBT T1 auf den im IGBT-Modus betriebenen rückwärts leitfähigen IGBT T2 erfolgt zum Zeitpunkt t3. Die Verriegelungszeit ΔT$_V$ ist notwendig, um einen Brückenzweig-Kurzschluss zu vermeiden. Diese Verriegelungszeit ΔT$_V$ führt aber wieder zu einem Anheben der Ladungsträgerkonzentration beim im Dioden-Modus betriebenen rückwärts leitfähigen IGBT T1 und damit zu einer Erhöhung der Schaltverluste.

Zum Zeitpunkt t5 wechselt die Soll-Ausgangsspannung $u^*_{AM}$ wieder von -U$_d$/2 auf +U$_d$/2. Der im IGBT-Modus betriebene rückwärts leitfähige IGBT T2 bleibt für eine vorbestimmte Zeitspanne $\Delta T_2$ angerechnet vom Zeitpunkt t5 weiter eingeschaltet, bevor dieser zum Zeitpunkt t6 abgeschaltet wird und der Ausgangsstrom i$_A$ auf den im Dioden-Modus betriebenen rückwärts leitfähigen IGBT T1 kommutiert.

Damit der Effekt der Anodeneffizienz wirkt, sollte die Verriegelungszeit $\Delta T_V$ zwischen dem Ausschalten des im Dioden-Modus betriebenen rückwärts leitfähigen IGBT T1 und dem Einschalten des im IGBT-Modus betriebenen rückwärts leitfähigen IGBT T2 möglichst klein sein. Das in der eingangs genannten Veröffentlichung offenbarte Steuerverfahren (Kommutierungsverfahren) ist zeitgesteuert, was eine hohe zeitliche Präzision erfordert. Ist die Anodeneffizienz hoch, ist die Durchlassspannung niedrig, so dass die Reverse Recovery-Verluste reduziert sind.

Der Erfindung liegt nun die Aufgabe zugrunde, das bekannte Verfahren zur Steuerung eines rückwärts leitfähigen IGBTs derart weiterzubilden, dass die Reverse-Recovery-Ladung möglichst niedrig wird in Kombination mit einer möglichst niedrigen Durchlassspannung, und dass im Dioden-Modus eine hohe Stoßstromfestigkeit erreicht wird.

Diese Aufgabe wird mit den Merkmalen des Anspruchs 1 erfindungsgemäß gelöst.

Dieser Erfindung liegt die Erkenntnis zugrunde, dass rückwärts leitfähige IGBTs parasitäre hochdotierte p-Gebiete zwischen kontaktierten p-Wannen auf der Vorderseite des RC-IGBTs aufweisen. Diese hochdotierten p-Gebiete sind nicht kontaktiert. Durch diese parasitären p-Gebiete weist der zugehörige rückwärts leitfähige IGBT anstelle von zwei nun drei Schaltzustände auf, nämlich die Schaltzustände "+15V", "0V" und "-15V".

Eine Untersuchung ergab folgende Tabelle, die die resultierenden Zustände für einen so genannten Tri-State-RC-IGBT zeigen:

| Zustandsbezeichnung | u$_{GE}$ | Ladungsträgerkonzentration im Durchlass | sperrfähig | Q$_{RR}$ W$_{RR}$ |
|---|---|---|---|---|
| +15 V | u$_{GE}$ > u$_{th(plus)}$ z.B. +15 V | sehr niedrig | nein | |
| 0 V | u$_{th(plus)}$ > u$_{GE}$ > u$_{th(minus)}$ z.B. 0 V | mittel | ja | mittel |
| -15 V | u$_{th(minus)}$ > u$_{GE}$ z.B. - 15 V | hoch | ja | hoch |

Der Schaltzustand "+15V" (erster Schaltzustand) wird dabei dadurch eingestellt, dass die Gate-Emitter-Spannung des IGBT auf einen Wert oberhalb der Einsetzspannung gebracht wird, wobei die Gate-Emitter-Spannung typischerweise aber nicht notwendigerweise auf 15V eingestellt wird. Mittels diesem Schaltzustand bildet sich ein leitfähiger Elektronenkanal derart in der p-Wanne aus, dass bei Stromführung vom Emitter zum Kollektor die Ladungsträgerkonzentration sehr niedrig ist, und dass der IGBT nicht sperrfähig ist.

Der Schaltzustand "0V" (dritter Schaltzustand) wird dadurch eingestellt, dass die Gate-Emitter-Spannung des IGBT auf einen Wert unterhalb der Einsetzspannung gebracht wird, wobei die Gate-Emitter-Spannung typischerweise aber nicht notwendigerweise auf 0V eingestellt wird, Dadurch bildet sich kein leitfähiger Elektronenkanal in der p-Wanne aus, wodurch bei Stromführung vom Emitter zum Kollektor die Ladungsträgerkonzentration mittelhoch ist, und wodurch der IGBT sperrfähig ist.

Der Schaltzustand "-15V" (zweiter Schaltzustand) wird dadurch eingestellt, dass die Gate-Emitter-Spannung des IGBT auf einen Wert unterhalb der Einsetzspannung gebracht wird, wobei die Gate-Emitter-Spannung typischerweise aber nicht notwendigerweise auf -15V eingestellt wird. Dadurch bildet sich kein leitfähiger Elektronenkanal in der p-Wanne aus, wodurch bei Stromführung vom Emitter zum Kollektor die Ladungsträgerkonzentration sehr hoch ist, und wodurch der IGBT sperrfähig ist.

Die Erfindung beruht nun darauf, dass die vorhandenen drei Schaltzustände "+15V", "0V" und "-15V" für ein Steuerverfahren verwendet werden, um die Reverse-Recovery-Ladung in Kombination mit einer möglichst niedrigen Durchlassspannung zu erniedrigen. Außerdem soll die Stoßstromfestigkeit im Dioden-Modus erhöht werden.

Mit diesem Verfahren wird bei einer Kommutierung von einem im Dioden-Modus betriebenen RC-IGBT auf einen im IGBT-Modus betriebenen RC-IGBT einer Halbbrücke durch Zwischenschaltung des dritten Schaltzustands "0V" beim Wechsel vom ersten Schaltzustand "+15V" zum zweiten Schaltzustand "-15V" des RC-IGBT erreicht, dass die Reverse-Recovery-Ladung bei gleicher Durchlassspannung gegenüber einem herkömmlichen Verfahren niedriger ist. Da dieser im Dioden-Modus betriebene RC-IGBT mit Ausnahme des Kommutierungs-Vorgangs im zweiten Schaltzustand "-15V" gesteuert wird, erhöht sich die Stoßstromfestigkeit.

Soll nur die Reverse-Recovery-Ladung bei einer möglichst niedrigen Durchlassspannung möglichst niedrig sein, so werden der im Dioden-Modus betriebene RC-IGBT und der im IGBT-Modus betriebene RC-IGBT im stationären Aus-Zustand jeweils nicht in den zweiten Schaltzustand "-15V", sondern in den dritten Schaltzustand "0V" gesteuert.

Soll die Stoßstromfestigkeit beim im Dioden-Modus betriebenen RC-IGBT möglichst hoch sein, bei nur etwas reduzierter Reverse-Recovery-Ladung, so werden dieser RC-IGBT und der im IGBT-Modus betriebene RC-IGBT einer Halbbrücke während einer zweiten vorbestimmten Zeitspanne nicht in den ersten Schaltzustand "+15V", sondern jeweils in den dritten Schaltzustand "0V" gesteuert.

Soll hingegen nur die Stoßstromfestigkeit eines im Dioden-Modus betriebenen RC-IGBTs möglichst hoch sein, so wird dieser RC-IGBT einer Halbbrücke während einer vorbestimmten zweiten und dritten Zeitspanne in den zweiten Schaltzustand "-15V" gesteuert. Somit befindet sich der im Dioden-Modus betriebene RC-IGBT während einer gesteuerten Schaltperiode im zweiten Schaltzustand "-15V".

Die beim erfindungsgemäßen Verfahren verwendeten vorbestimmten Zeitspannen sind derart bemessen, dass die erste Zeitspanne gegenüber der zweiten Zeitspanne größer ist, aber gegenüber einer Summe der zweiten und dritten Zeitspanne kleiner ist. Diese drei vorbestimmten Zeitspannen sind als Zahlenwerte in einer Vorrichtung zur Durchführung des erfindungsgemäßen Verfahrens, insbesondere jeweils einer Ansteuervorrichtung eines RC-IGBTs einer Halbbrücke, hinterlegt. Diese Zeitspannen werden von der positiven bzw. negativen Schaltflanke eines Soll-Steuersignals eines anzusteuernden RC-IGBTs getriggert. Mit diesen hinterlegten Zeitspannen kann das erfindungsgemäße Verfahren einfach umgesetzt werden.

Zur weiteren Erläuterung der Erfindung wird auf die Zeichnung Bezug genommen, in der mehrere Ausführungsformen des erfindungsgemäßen Verfahrens schematisch veranschaulicht sind.

| | |
|---|---|
| FIG 1 | zeigt einen Querschnitt einer Basisstruktur eines rückwärts leitfähigen IGBTs, in der |
| FIG 2 | ist ein Ersatzschaltbild eines Brückenzweigs eines Stromrichters mit zwei rückwärts leitenden IGBTs dargestellt, die |
| FIG 3 | zeigt ein Blockschaltbild einer Steuer- und Regeleinrichtung eines dreiphasigen Stromrichters mit rückwärts leitfähigen IGBTs als Stromrichterventile, die |
| FIG 4 bis 8 | zeigen Signalverläufe zweier rückwärts leitfähiger IGBTs für den Fall eines negativen Ausgangsstroms dieser Halbbrücke, in der |
| FIG 9 | ist ein Querschnitt durch einen rückwärts leitfähigen IGBT mit drei Schaltzuständen dargestellt, die |
| FIG 10, 19, 23, 27 und 12, 21, 25 und 29 | zeigen jeweils in einem Diagramm über der Zeit t ein Soll-Steuersignal eines RC-IGBTs im IGBT-Modus und im Dioden-Modus, in den |
| FIG 11 und 13 | sind jeweils in einem Diagramm über der Zeit t zughörige Gate-Spannungen gemäß dem erfindungsgemäßen Verfahren dargestellt, in den |
| FIG 14 bis 18 | sind Signalverläufe zweier rückwärts leitfähiger IGBTs einer Halbbrücke für den Fall eines negativen Ausgangsstroms der Halbbrücke des erfindungsgemäßen Verfahrens dargestellt, die |
| FIG 20 und 22 | zeigen jeweils in einem Diagramm über der Zeit t Gate-Spannungen gemäß einem modifizierten erfindungsgemäßen Verfahren, wogegen in den |
| FIG 24, 26 und 28, 30 | jeweils Gate-Spannungen weiterer modifizierter erfindungsgemäßer Verfahren jeweils in einem Diagramm über der Zeit t dargestellt sind. |

In FIG 9 ist ein Querschnitt eines RC-IGBTs mit drei schaltbaren Zuständen (+15V, 0V, -15V) schematisch dargestellt. Dieser RC-IGBT unterscheidet sich vom RC-IGBT gemäß FIG 1 dadurch, dass dieser parasitäre hochdotierte p-Gebiete $P_p$ aufweist. Diese hochdotierten p-Gebiete $P_p$ sind zwischen kontaktierten p-Wannen $W_p$ auf der Vorderseite des RC-IGBTs angeordnet. Diese hochdotierten p-Gebiete $P_p$ sind nicht mit einer Elektrode des RC-IGBTs kontaktiert.

Es wurde nun erkannt, dass durch diese parasitären hochdotierten p-Gebiete $P_p$ dieser RC-IGBTs gegenüber einem herkömmlichen RC-IGBT (FIG 1) einen dritten Schaltzustand "0V" aufweist, der auch gezielt angesteuert werden kann. Neben den beiden Schaltzuständen "+15V" und "-15V" des herkömmlichen RC-IGBT gemäß FIG 1 weist der RC-IGBT gemäß FIG 9 zusätzlich den Schaltzustand "0V" auf.

Die Signalverläufe der FIG 10 bis 30 sind für den Fall dargestellt, dass der Ausgangsstrom $i_A$ der Halbbrücke 2 negative Polarität aufweist, der RC-IGBT T1 dieser Halbbrücke im Dioden-Modus (negativer Kollektorstrom) und der RC-IGBT T2 dieser Halbbrücke 2 im IGBT-Modus (positiver Kollektorstrom) betrieben werden. Die FIG 10 und 11 zeigen die Verläufe eines Soll-Steuersignals $S_T^*$ und einer zugehörigen Gate-Spannung $U_{GE}$ eines im IGBT-Modus betriebenen RC-IGBTs, wogegen die FIG 12 und 13 die Verläufe eines Soll-Steuersignals $S_T^*$ und einer zugehörigen Gate-Spannung

$u_{GE}$ eines im Dioden-Modus betriebenen RC-IGBTs zeigen.

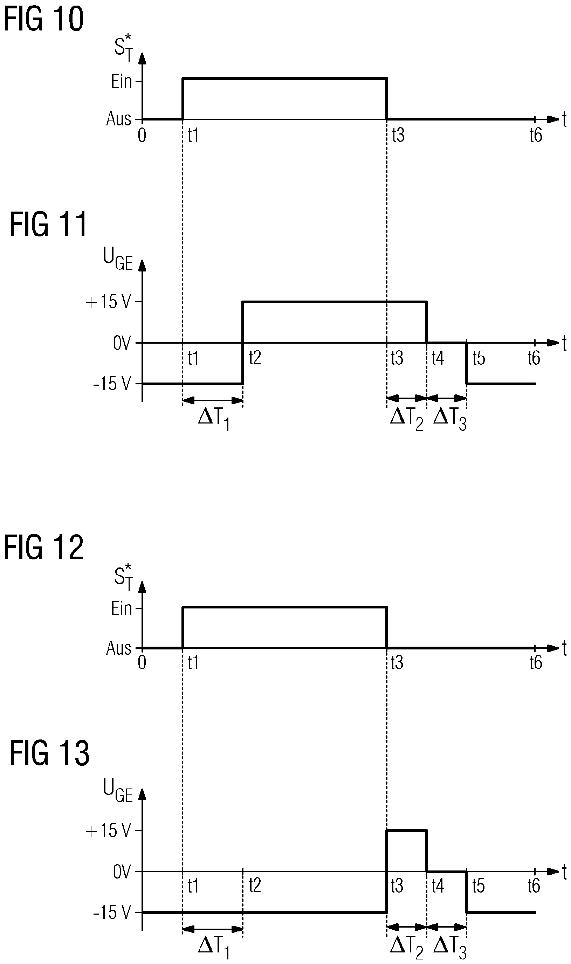

Gemäß dem Diagramm der FIG 10 wechselt das Soll-Steuersignal $S_T^*$ zum Zeitpunkt t1 vom Aus-Zustand in den Ein-Zustand. Mit dieser positiven Schaltflanke wird eine erste vorbestimmte Zeitspanne $\Delta T_1$ gestartet. Zum Zeitpunkt t2 ist diese vorbestimmte Zeitspanne $\Delta T_1$ abgelaufen. Ab diesem Zeitpunkt t2 wechselt die Gate-Spannung $u_{GE}$ des im IGBT-Modus betriebenen RC-IGBTs von Schaltzustand "-15V" in den Schaltzustand "+15V". Zum Zeitpunkt t3 wechselt wieder das Soll-Steuersignal $S_T^*$ eines im IGBT-Modus betriebenen RC-IGBTs vom Ein-Zustand in den Aus-Zustand. Mit dieser negativen Schaltflanke wird eine zweite vorbestimmter Zeitspanne $\Delta T_2$ gestartet, die zum Zeitpunkt t4 abgelaufen ist. Mit Ablauf dieser zweiten vorbestimmten Zeitspanne $\Delta T_2$ wird eine dritte vorbestimmte Zeitspanne $\Delta T_3$ gestartet. Diese endet zum Zeitpunkt t5. Während der zweiten Zeitspanne $\Delta T_2$ verharrt die Gate-Spannung $u_{GE}$ des im IGBT-Modus betriebenen RC-IGBTs in den Schaltzustand "+15V". Zum Zeitpunkt t4, zu dem die zweite Zeitspanne $\Delta T_2$ abgelaufen ist und die dritte vorbestimmte Zeitspanne $\Delta T_3$ gestartet ist, wechselt die Gate-Spannung $u_{GE}$ vom Schaltzustand "+15V" in den Schaltzustand "0V". Nach Ablauf dieser dritten vorbestimmten Zeitspanne $\Delta T_3$, also zum Zeitpunkt t5, wechselt die Gate-Spannung $u_{GE}$ seinen Zustand vom Schaltzustand "0V" in den Schaltzustand "-15V".

Der Verlauf der Gate-Spannung $u_{GE}$ eines im Dioden-Modus betriebenen RC-IGBTs ist in dem Diagramm über der Zeit t der FIG 13 dargestellt. Diese Gate-Spannung $u_{GE}$ verharrt im Schaltzustand "-15V" bis zum Zeitpunkt t3 der negativen Schaltflanke des Soll-Steuersignals $S_T^*$. Zu diesem Zeitpunkt t3 wird die zweite vorbestimmte Zeitspanne $\Delta T_2$ gestartet und die Gate-Spannung $u_{GE}$ wechselt vom Schaltzustand "-15V" in den Schaltzustand "+15V" und verharrt in diesem Zustand für die Dauer der zweiten vorbestimmten Zeitspanne $\Delta T_2$. Zum Zeitpunkt t4 ist diese zweite vorbestimmte Zeitspanne $\Delta T_2$ abgelaufen. Nach Ablauf dieser zweiten vorbestimmten Zeitspanne $\Delta T_2$, wechselt die Gate-Spannung $u_{GE}$ vom Schaltzustand "+15V" in den Schaltzustand "0V" und verharrt in diesem Schaltzustand, bis die dritte vorbestimmte Zeitspanne $\Delta T_3$ abgelaufen ist. Zum Zeitpunkt t6 endet eine Pulsperiode $T_P$ des Soll-Steuersignals $S_T^*$ und es beginnt eine neue Pulsperiode $T_P$.

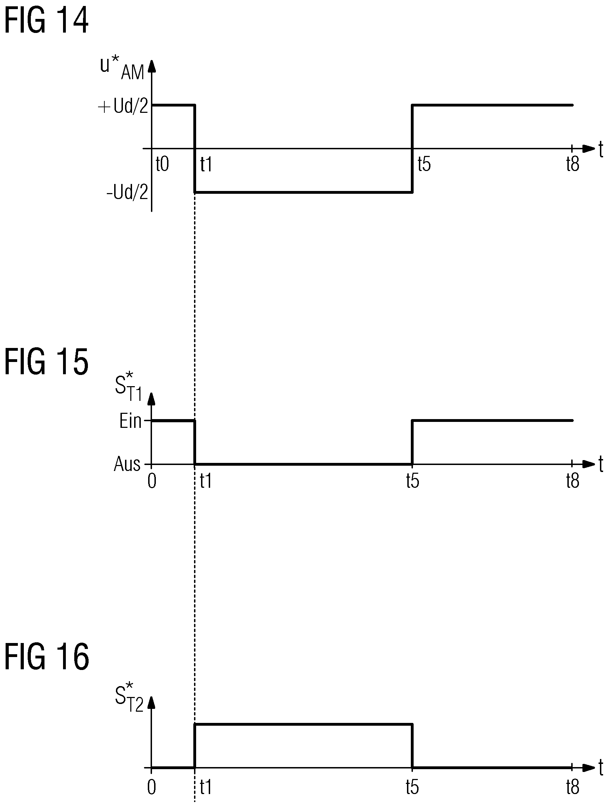

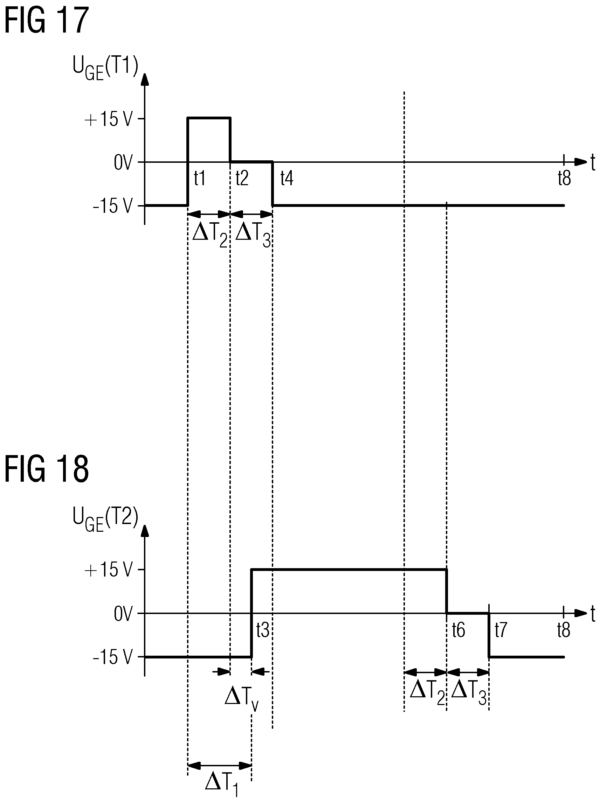

Diese erfindungsgemäße Steuerung eines im IGBT-Modus betriebenen RC-IGBTs und eines im Dioden-Modus betriebenen RC-IGBTs zweier elektrisch in Reihe geschalteter rückwärts leitfähiger IGBTs der Halbleiterbrücke 2 ist gemäß FIG 3 angewendet worden. Die zugehörigen Signalverläufe sind in den Diagrammen der FIG 14 bis 18 dargestellt. In dem Diagramm der FIG 14 ist der Verlauf der Soll-Ausgangsspannung $u_{AM}^*$ über der Zeit t dargestellt. Dieser Verlauf entspricht dem Verlauf der Soll-Ausgangsspannung $u_{AM}^*$ der FIG 4. Um diese Soll-Ausgangsspannung $u_{AM}^*$ umsetzen zu können, werden die beiden Soll-Steuersignale $S_{T1}^*$ und $S_{T2}^*$ für die beiden RC-IGBTs T1 und T2 der Halbleiterbrücke 2 benötigt, die jeweils in einem Diagramm über der Zeit t in den FIG 15 und 16 dargestellt sind. Diese entsprechen den Steuersignalen $S_{T1}^*$ und $S_{T2}^*$ der FIG 5 und 6. Wie bereits erwähnt, wird bei negativer Polarität des Ausgangsstroms $i_A$ der Halbbrücke 2 der RC-IGBT T1 im Dioden-Modus und der RC-IGBT T2 im IGBT-Modus betrieben. In den FIG 17 und 18 sind die Verläufe der jeweiligen Gate-Spannungen $u_{GE}(T1)$ und $u_{GE}(T2)$ der beiden RC-IGBTs T1 und T2 der Halbbrücke 2 zeitlich dargestellt. Das heißt, die Gate-Spannungsverläufe gemäß FIG 13 und 11 sind entsprechend den Verläufen der Soll-Steuersignale $S_{T1}^*$ und $S_{T2}^*$ der FIG 15 und 16 in den FIG 17 und 18 eingetragen.

Gemäß dem erfindungsgemäßen Verfahren befindet sich der im Dioden-Modus betriebene RC-IGBT T1 während seiner stationären Leitphase (t<t1 und t>t7) im Schaltzustand "-15V". Dadurch weist dieser RC-IGBT T1 eine minimale Durchlassspannung auf. Vor dem Reverse-Recovery wird der im Dioden-Modus betriebene RC-IGBT T1 in den Schaltzustand "+15V" (t=t1) und nach Ablauf der zweiten vorbestimmten Zeitspanne $\Delta T_2$ in den Schaltzustand "0V" gesteuert. Während der zweiten Zeitspanne $\Delta T_2$ ist der im Dioden-Modus betriebene RC-IGBT T1 stromführend, wodurch die Ladungsträgerkonzentration abnimmt. Nach Ablauf der zweiten Zeitspanne $\Delta T_2$ wird dieser im Dioden-Modus betriebene RC-IGBT T1 wieder abgeschaltet.

Gegenüber dem bekannten Steuerverfahren wird der im Dioden-Modus betriebene RC-IGBT T1 nicht in den Schaltzustand "-15V" gesteuert, sondern in den neuen Schaltzustand "0V". In diesem neuen Schaltzustand verharrt dieser RC-IGBT T1 so lange, bis die dritte vorbestimmte Zeitspanne $\Delta T_3$ abgelaufen ist. Während dieser dritten Zeitspanne $\Delta T_3$ läuft ebenfalls die Verriegelungszeit $\Delta T_V$ ab, die ebenfalls nach Ablauf der zweiten vorbestimmten Zeitspanne $\Delta T_2$ gestartet worden ist. Sobald diese Verriegelungszeit $\Delta T_V$ abgelaufen ist, wird der im IGBT-Modus betriebene RC-IGBT T2 vom Schaltzustand "-15V" in den Schaltzustand "+15V" gesteuert. Damit erfolgt die Kommutierung vom im Dioden-Modus betriebenen RC-IGBT T1 auf den im IGBT-Modus betriebenen RC-IGBT T2.

Gemäß dem erfindungsgemäßen Verfahren gelangt der im Dioden-Modus betriebene RC-IGBT T1 während der dritten vorbestimmten Zeitspanne $\Delta T_3$ nicht wieder in den Schaltzustand (-15V) hoher Ladungsträgerkonzentration, sondern in einem Zustand mittlerer Ladungsträgerkonzentration, weil dieser sich unmittelbar vor dem Reverse-Recovery im Schaltzustand "0V", und nicht wie beim bekannten Steuerverfahren im Schaltzustand "-15V" befindet. Dadurch sinkt die Reverse-Recovery-Ladung bei gleicher Durchlassspannung gegenüber dem Stand der Technik. Somit ist das erste Ziel erreicht.

Wenn der im Dioden-Modus betriebene RC-IGBT T1 ein- bzw. ausgeschaltet wird, treten Stoßstrombelastungen in Diodenrichtung dieses RC-IGBTs T1 auf. Damit der im Dioden-Modus betriebene RC-IGBT T1 eine höhere Stoßstromfestigkeit aufweist, befindet sich dieser im Schaltzustand "-15V" (t<t1 und t>t4).

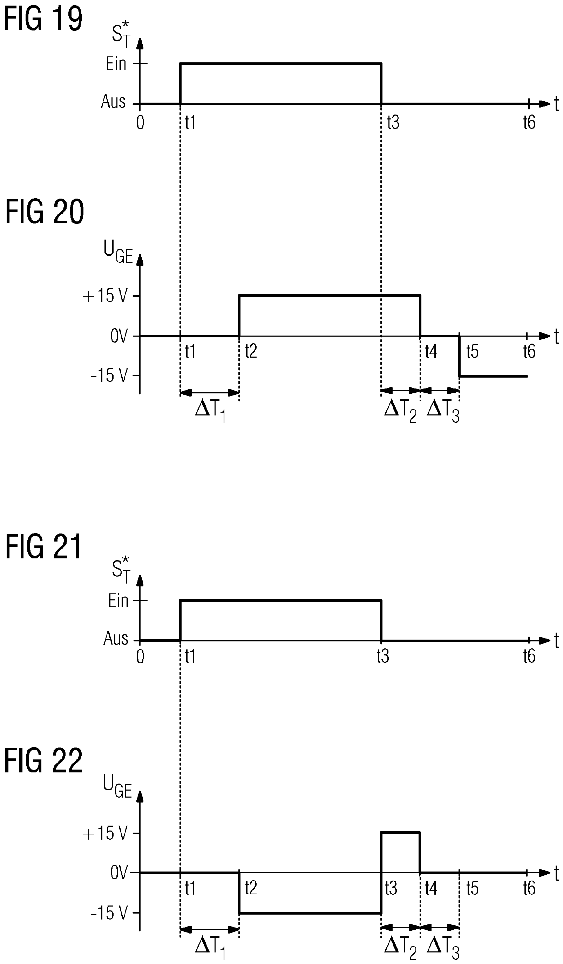

In den FIG 20 und 22 ist eine erste Modifikation des erfindungsgemäßen Verfahrens dargestellt. Die Modifikation besteht darin, dass im stationären Aus-Zustand (t<t2 und t>t5) die beiden RC-IGBTs T1 und T2 nicht in den Schaltzustand "-15V", sondern in den Schaltzustand "0V" gesteuert werden. Mit dieser Modifikation des erfindungsgemäßen Verfahrens wird nur die Reverse-Recovery-Ladung bei einer möglichst niedrigen Durchlassspannung erniedrigt. Die Stoßstromfestigkeit des im Dioden-Modus betriebenen RC-IGBTs T1 wird nicht wesentlich erhöht.

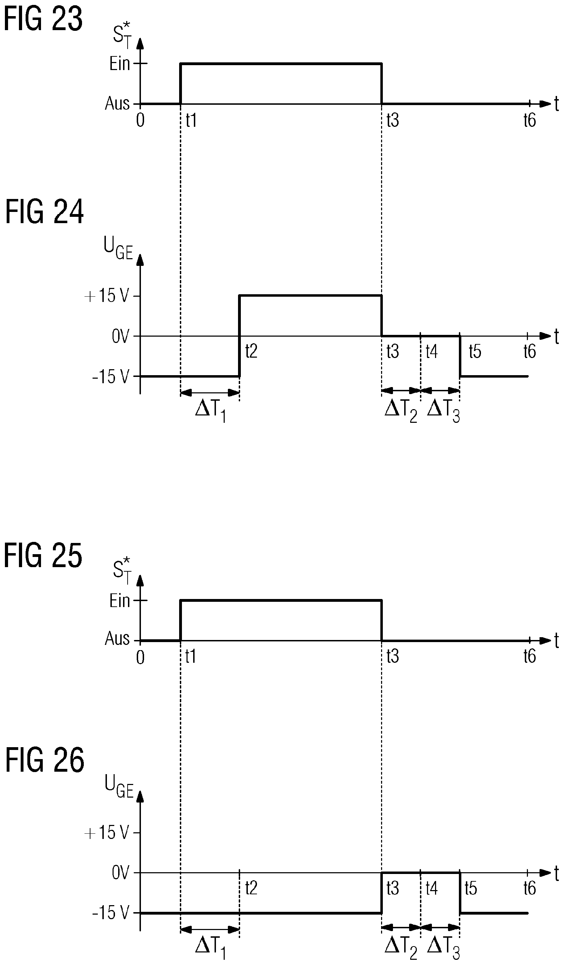

Bei einer weiteren Modifikation des erfindungsgemäßen Verfahrens wird der im Dioden-Modus betriebene RC-IGBT während des Soll-Ein-Zustandes (t1<t<t3 der FIG 25) und während des stationären Sperrzustands (t<t1 und t>t5 der FIG 26) in den Schaltzustand "-15V" gesteuert. Dadurch wird erreicht, dass der im Dioden-Modus betriebene RC-IGBT eine hohe Stoßstromfestigkeit aufweist. Da dieser im Dioden-Modus betriebene RC-IGBT während der zweiten und dritten vorbestimmten Zeitspanne $\Delta T_2$ und $\Delta T_3$ im Schaltzustand "0V" verharrt, sinkt die Ladungsträgerkonzentration während der zweiten vorbestimmten Zeitspanne $\Delta T_2$ nicht zu sehr ab, wie beim Stand der Technik bzw. beim erfindungsgemäßen Verfahren (FIG 13). Diese Ladungsträgerkonzentration nimmt aber auch während der dritten vorbestimmten Zeitspanne $\Delta T_3$ nur minimal zu, da der im Dioden-Modus betriebene RC-IGBT während dieser Zeitspanne $\Delta T_3$ im Schaltzustand "0V" gehalten wird.

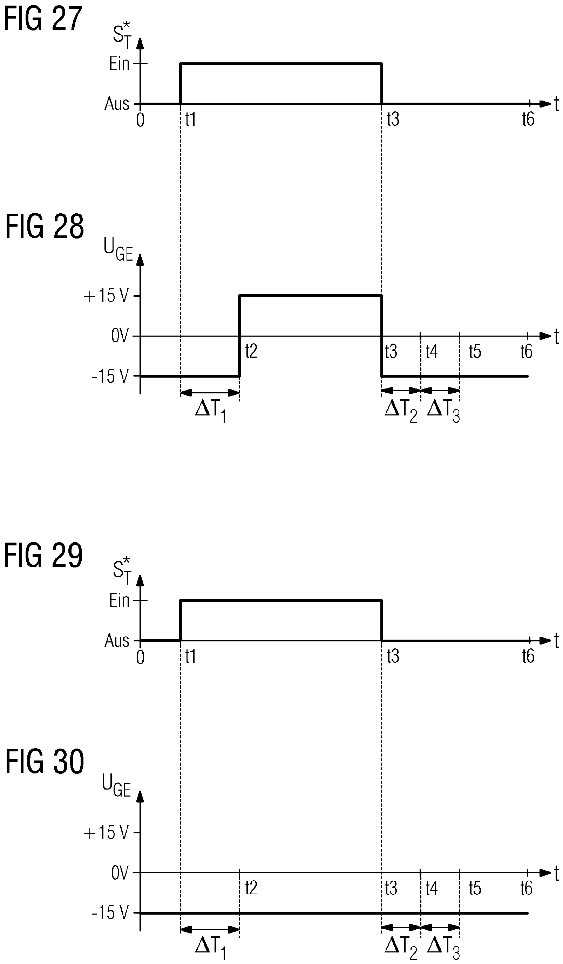

Wird nur eine hohe Stoßstromfestigkeit im Dioden-Modus eines RC-IGBTs verlangt, so kann der im Dioden-Modus betriebene RC-IGBT während der gesamten Pulsperiode in den zweiten Schaltzustand "-15V" gesteuert werden (FIG 30). Diese Modifikation ist allerdings nicht Teil des erfindungsgemäßen Verfahrens da die Reverse-Recovery-Ladung nicht reduziert wird.

Damit das erfindungsgemäße Verfahren ohne großen Aufwand realisiert werden kann, werden in den Aussteuervorrichtungen 14 eines jeden RC-IGBTs T1 bzw. T2 der Halbbrücke 2 (FIG 3) die vorbestimmten Zeitspannen $\Delta T_1$, $\Delta T_2$ und $\Delta T_3$ als konstante Zahlenwerte hinterlegt. Für das Umsetzen des erfindungsgemäßen Verfahrens werden diese drei Zeitspannen $\Delta T_1$, $\Delta T_2$ und $\Delta T_3$ derart bemessen, dass Folgendes gilt: $\Delta T_2 < \Delta T_1 < \Delta T_2 + \Delta T_3$. Voraussetzung für die Verwendung des erfindungsgemäßen Verfahrens besteht darin, dass die rückwärts leitfähigen IGBTs parasitäre nicht kontaktierte hoch dotierte p-Gebiete zwischen kontaktierten p-Wannen auf der Vorderseite des RC-IGBTs aufweisen. Durch diese parasitären p-Gebiete weist der RC-IGBT anstelle von zwei Schaltzuständen ("+15V" und "-15V") nun drei Schaltzustände ("+15V", "0V" und "-15V") auf. Erfindungsgemäß werden diese parasitären p-Gebiete eines RC-IGBTs gezielt beim Steuerverfahren dieses RC-IGBTs verwendet, um vorrangig möglichst eine niedrige Reverse-Recovery-Ladung mit einer möglichst niedrigen Durchlassspannung zu erhalten.

## Patentansprüche

1. Verfahren zur Steuerung zweier elektrisch in Reihe geschalteter rückwärts leitfähiger IGBTs (T1, T2) einer Halbbrücke (2), an der eine Betriebsgleichspannung ($U_G$) ansteht, wobei diese rückwärts leitfähigen IGBTs (T1, T2) einen ersten Schaltzustand (+15V), einen zweiten Schaltzustand (-15V) und einen dritten Schaltzustand (0V) aufweisen, wobei der erste Schaltzustand (+15V) dadurch eingestellt wird, dass die Gate-Emitter-Spannung oberhalb der Einsetzspannung gebracht wird, wobei der zweite Schaltzustand (-15V) und der dritte Schaltzustand (0V) dadurch eingestellt werden, dass die Gate-Emitter-Spannung unterhalb der Einsetzspannung gebracht wird, wobei die Gate-Emitter-Spannung des zweiten Schaltzustands (-15V) niedriger ist als die des dritten Schaltzustands (0V), wobei die Polarität des Kollektorstroms eines jeden rückwärts leitfähigen IGBTs (T1, T2) einer Halbbrücke (2) ermittelt wird, mit folgenden Verfahrensschritten:

   a) Setzen eines jeden rückwärts leitfähigen IGBTs (T1, T2) der Halbbrücke (2) während eines stationären Aus-Zustands eines zugehörigen Soll-Steuersignals ($S_T^*$) in den zweiten Schaltzustand (-15V) oder in den dritten Schaltzustand (0V),
   b) Halten eines rückwärts leitfähigen IGBTs (T1, T2) in dem zweiten Schaltzustand (-15V) nach Ablauf einer

vorbestimmten Zeitspanne ($\Delta T_1$) nach Wechsel eines zugehörigen Soll-Steuersignals ($S_T^*$) vom Aus-Zustand in einen Ein-Zustand, solange ein Strom vom Emitter zum Kollektor fließt,

c) Setzen eines rückwärts leitfähigen IGBTs (T1, T2) in den ersten Schaltzustand (+15V) nach Ablauf der vorbestimmten Zeitspanne ($\Delta T_1$) nach Wechsel eines zugehörigen Soll-Steuersignals ($S_T^*$) vom Aus-Zustand in den Ein-Zustand, wenn dadurch ein Stromfluss vom Kollektor zum Emitter ermöglicht wird,

d) Setzen eines jeden rückwärts leitfähigen IGBTs (T1, T2) der Halbbrücke (2) nach Ablauf einer zweiten vorbestimmten Zeitspanne ($\Delta T_2$) für eine dritte vorbestimmte Zeitspanne ($\Delta T_3$) in den dritten Schaltzustand (0V), wobei die zweite vorbestimmte Zeitspanne ($\Delta T_2$) mit dem Wechsel eines zugehörigen Soll-Steuersignals ($S_T^*$) vom Ein- in den Aus-Zustand gestartet wird.

2. Verfahren nach Anspruch 1, **gekennzeichnet durch** Setzen eines jeden rückwärts leitfähigen IGBTs (T1, T2) der Halbbrücke (2) in den ersten Schaltzustand (+15V) für die zweite vorbestimmte Zeitspanne ($\Delta T_2$).

3. Verfahren nach Anspruch 1, **dadurch gekennzeichnet, dass** die Amplitude der Gate-Spannung ($u_{GE}$) eines jeden rückwärts leitfähigen IGBTs (T1, T2) der Halbbrücke (2) für die zweite vorbestimmte Zeitspanne ($\Delta T_2$) in den dritten Schaltzustand (0V) gesetzt wird.

4. Verfahren nach einem der Ansprüche 1 bis 3, **dadurch gekennzeichnet, dass** die erste vorbestimmte Zeitspanne ($\Delta T_1$) zeitlich größer ist als die zweite vorbestimmte Zeitspanne ($\Delta T_2$).

5. Verfahren nach einem der Ansprüche 1 bis 4, **dadurch gekennzeichnet, dass** die erste vorbestimmte Zeitspanne ($\Delta T_1$) zeitlich kleiner ist als die Summe der zweiten und dritten vorbestimmten Zeitspannen ($\Delta T_2$, $\Delta T_3$).

6. Verfahren nach einem der Ansprüche 1 bis 5, **dadurch gekennzeichnet, dass** die drei vorbestimmten Zeitspannen ($\Delta T_1$, $\Delta T_2$, $\Delta T_3$) in einer Vorrichtung zur Durchführung des Verfahrens hinterlegt sind.

7. Verfahren nach einem der Ansprüche 1 bis 6, **dadurch gekennzeichnet, dass** die Polarität eines Kollektorstroms durch Auswertung einer ermittelten Kollektor-Emitter-Spannung bestimmt wird.

**Claims**

1. Method for control of two electrically series-connected reverse conductive IGBTs (T1, T2) of a half bridge (2), at which an operating DC voltage ($U_G$) is present, wherein these reverse conductive IGBTs (T1, T2) have a first switching state (+15V), a second switching state (-15V) and a third switching state (0V), wherein the first switching state (+15V) is adjusted such that the gate emitter voltage is brought above the inception voltage, wherein the second switching state (-15V) and the third switching state (0V) are adjusted such that the gate emitter voltage is brought below the inception voltage, wherein the gate emitter voltage of the second switching state (-15V) is lower than that of the third switching state (0V), wherein the polarity of the collector current of each reverse conductive IGBT (T1, T2) of a half bridge (2) is determined, with the following method steps:

a) Setting each reverse conductive IGBT (T1, T2) of the half bridge (2) during a stationary off state of an associated desired control signal ($S_T^*$) into the second switching state (-15V") or into the third switching state (0V),

b) Holding a reverse conductive IGBT (T1, T2) in the second switching state (-15V) after a predetermined period of time ($\Delta T_1$) has elapsed after an associated desired control signal ($S_T^*$) has changed from the off state into an on state while a current is flowing from the emitter to the collector,

c) Setting a reverse conductive IGBT (T1, T2) into the first switching state (+15V) after the predetermined period of time ($\Delta T_1$) has elapsed after an associated desired control signal ( $S_T^*$ ) has changed from the off state into the on state, if a flow of current from the collector to the emitter is made possible by this,

d) Setting each reverse conductive IGBT (T1, T2) of the half bridge (2) into the third switching state (0V) for a third predetermined period of time ($\Delta T_3$) after a second predetermined period of time ($\Delta T_2$) has elapsed, wherein the second predetermined period of time ($\Delta T_2$) is started with the change in an associated desired control signal

( $S_T^*$ ) from the on state into the off state.

2. Method according to claim 1,
**characterised by** setting each reverse conductive IGBT (T1, T2) of the half bridge (2) into the first switching state (+15V) for the second predetermined period of time ($\Delta T_2$).

3. Method according to claim 1,
**characterised in that** the amplitude of the gate voltage ($u_{GE}$) of each reverse conductive IGBT (T1, T2) of the half bridge (2) is set for the second predetermined period of time ($\Delta T_2$) into the third switching state (0V).

4. Method according to one of claims 1 to 3,
**characterised in that** the first predetermined period of time ($\Delta T_1$) is longer than the second predetermined period of time ($\Delta T_2$) .

5. Method according to one of claims 1 to 4,
**characterised in that** the first predetermined period of time ($\Delta T_1$) is shorter than the sum of the second and third predetermined periods of time ($\Delta T_2$, $\Delta T_3$).

6. Method according to one of claims 1 to 5,
**characterised in that** the three predetermined periods of time ($\Delta T_1$, $\Delta T_2$, $\Delta T_3$) are stored in a facility for carrying out the method.

7. Method according to one of claims 1 to 6,
**characterised in that** the polarity of a collector current is determined by evaluating a determined collector-emitter voltage.

**Revendications**

1. Procédé de commande de deux IGBT (T1, T2) à conduction inverse montés électriquement en série, d'un demi pont (2) auquel s'applique une tension ($U_G$) continue de fonctionnement, ces IGBT (T1, T2) à conduction inverse ayant un premier état (+15V) de commutation, un deuxième état (-15V) de commutation et un troisième état (0V) de commutation, le premier état (+15V) de commutation étant établi par le fait de mettre la tension grille-émetteur au dessus de la tension de seuil, dans lequel le deuxième état (-15V) de commutation et le troisième état (0V) de commutation sont établis par le fait que la tension grille-émetteur est mise en dessous de la tension de seuil, dans lequel la tension de grille-émetteur du deuxième état (-15V) de commutation est plus basse que celle du troisième état (0V) de commutation, dans lequel on détermine la polarité du courant de collecteur de chaque IGBT (T1, T2) à conduction inverse d'un demi-pont (2),
comprenant les stades de procédé suivants :

a) mise de chaque IGBT (T1, T2) à conduction inverse du demi-pont (2), pendant un état ouvert stationnaire d'un signal ($S^*_T$) de commande de consigne associé, dans le deuxième état (-15V) de commutation ou dans le troisième état (0V) de commutation,
b) maintien d'un IGBT (T1, T2) à conduction inverse dans le deuxième état (-15V) de commutation après écoulement d'un laps de temps ($\Delta T_1$) défini à l'avance, après passage d'un signal ($S^*_T$) de commande de consigne associé de l'état ouvert à un état fermé, tant qu'un courant passe de l'émetteur au collecteur,
c) mise d'un IGBT (T1, T2) à conduction inverse dans le premier état (+15V) de commutation après écoulement du laps de temps ($\Delta T_1$) défini à l'avance, après passage d'un signal ($S^*_T$) de commande de consigne associé de l'état ouvert à l'état fermé, si un flux de courant du collecteur à l'émetteur est rendu possible,
d) mise de chaque IGBT (T1, T2) à conduction inverse du demi-pont après écoulement d'un deuxième laps de

temps ($\Delta T_2$ défini à l'avance pendant un troisième laps de temps ($\Delta T_3$) défini à l'avance dans le troisième état (0V) de commutation, le deuxième laps de temps ($\Delta T_2$) défini à l'avance commençant avec le passage d'un signal ($S^*_T$) de commande de consigne associé de l'état fermé à l'état ouvert.

2. Procédé suivant la revendication 1, **caractérisé par** la mise d'un IGBT (T1, T2) à conduction inverse du demi-pont (2) dans le premier état (+15V) de commutation pendant le deuxième laps de temps ($\Delta T_2$) défini à l'avance.

3. Procédé suivant la revendication 1,
**caractérisé en ce que** l'on met dans le troisième état (0V) de commutation, pendant le deuxième laps de temps ($\Delta T_2$) défini à l'avance, la tension ($U_{GE}$) de grille de chaque IGBT (T1, T2) à conduction inverse du demi-pont (2).

4. Procédé suivant l'une des revendications 1 à 3,
**caractérisé en ce que** le premier laps de temps ($\Delta T_1$) défini à l'avance est plus grand en temps que le deuxième laps de temps ($\Delta T_2$) défini à l'avance.

5. Procédé suivant l'une des revendications 1 à 4,
**caractérisé en ce que** le premier laps de temps ($\Delta T_1$) défini à l'avance est plus petit en temps que la somme des deuxième et troisième laps de temps ($\Delta T_2$, $\Delta T_3$) définis à l'avance.

6. Procédé suivant l'une des revendications 1 à 5,
**caractérisé en ce que** les trois laps de temps ($\Delta T_1$, $\Delta T_2$, $\Delta T_3$) définis à l'avance sont mémorisés dans un système pour effectuer le procédé.

7. Procédé suivant l'une des revendications 1 à 6,
**caractérisé en ce que** l'on détermine la polarité d'un courant de collecteur en exploitant une tension de collecteur-émetteur déterminée.

## FIG 1

## FIG 2

## FIG 3

FIG 4

FIG 5

FIG 6

## FIG 7

$U_{GE}(T1)$

+15 V

0 V

t0  t1  t2

t

-15 V

## FIG 8

$U_{GE}(T2)$

$\Delta T_1$

+15 V

0 V

t0  t1  t2  t3          t5  t6

t

-15 V

$\Delta T_V$          $\Delta T_2$

## FIG 9

$SiO_2$   $M_G$   $P_p$   $S_{n+}$   $M_E$

$W_p$

$P_p$

$M_G$

$SiO_2$

$S_n$

$F_S$

$M_K$

$L_n$   $L_n$

$S_p$

FIG 10

FIG 11

FIG 12

FIG 13

FIG 14

FIG 15

FIG 16

EP 2 638 623 B1

FIG 17

$U_{GE}(T1)$

+15 V

0V

t1 t2 t4

-15 V

$\Delta T_2$ $\Delta T_3$

t8

FIG 18

$U_{GE}(T2)$

+15 V

0V

t3

-15 V

$\Delta T_v$

$\Delta T_1$

t6 t7 t8

$\Delta T_2$ $\Delta T_3$

EP 2 638 623 B1

FIG 19

FIG 20

FIG 21

FIG 22

18

**FIG 23**

**FIG 24**

**FIG 25**

**FIG 26**

FIG 27

FIG 28

FIG 29

FIG 30

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009030740 A1

**In der Beschreibung aufgeführte Nicht-Patentliteratur**

- **M. RAHIMO ; U. SCHLAPBACH ; A. KOPTA ; J. VOBECKY ; D. SCHNEIDER ; A. BASCHNAGEL.** A High Current 3300V Module Employing Reverse Conducting IGBTs Setting a New Benchmark in Output Power Capability. *ISPSD,* 2008